# EUROPEAN PATENT APPLICATION

(11) **EP 3 806 156 A1**
(43) Date of publication of application: **14.04.2021**
(21) Application number: 19752068.7
(22) Date of filing: 15.02.2019
(51) Int. Cl.: H01L 27/32, H01L 51/52, H01L 51/56

(54) **DISPLAY SUBSTRATE AND MANUFACTURING METHOD THEREFOR, AND DISPLAY PANEL**

(30) Priority: 31.05.2018 CN 201810548135
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HU, Hungchieh, Beijing 100176 (CN); FENG, Yu Hsiung, Beijing 100176 (CN)
(74) Representative: Klunker IP Patentanwälte PartG mbB
(86) International application number: PCT/CN2019/075240
(87) International publication number: WO 2019/227970

(57) **Abstract**

A display substrate and a manufacturing method thereof, and a display panel are provided. The display substrate includes a first insulating layer (200), a pixel defining layer (300), a first electrode layer (410) and a plurality of organic light-emitting functional layers (430), the pixel defining layer (300) is located at a side of the first insulating layer (200), a plurality of first openings (210) in the first insulating layer (200) are in a one-to-one correspondence relationship with and communicate with a plurality of second openings (310) in the pixel defining layer (300), the plurality of organic light-emitting functional layers (430) are located in the second opening (310), the first electrode layer (410) is located at a side of the first insulating layer (200) opposite to the pixel defining layer (300), and an orthographic projection of the first insulating layer (200) on a plane where the display substrate is located at least partially overlaps with an orthographic projection of a peripheral region of the second openings (310) on the plane. The first insulating layer (200) can improve the uniformity of light emitted by the organic light-emitting functional layer (430) and improve the display effect of the display substrate.

## Description

This application claims priority to Chinese patent application No. 201810548135.X filed on May 31, 2018, the disclosure of which is incorporated herein by reference in its entirety as part of this application.

### TECHNICAL FIELD

At least one embodiment of the present disclosure relates to a display substrate and a manufacturing method thereof, and a display panel.

### BACKGROUND

Organic Light-Emitting Diode (OLED) has the advantages of self-luminescence, wide viewing angle, high contrast, low power consumption, high reaction speed and the like, and thus OLED display products are more and more popular with users.

### SUMMARY

At least one embodiment of the present disclosure provides a display substrate, the display substrate comprises a first insulating layer, a pixel defining layer, a first electrode layer and a plurality of organic light-emitting functional layers, the first insulating layer comprises a plurality of first openings, the pixel defining layer is located at a side of the first insulating layer and comprises a plurality of second openings which are in a one-to-one correspondence relationship with the plurality of first openings, the second opening communicates with the first opening corresponding to the second opening, the plurality of organic light-emitting functional layers are located in the second opening, the first electrode layer is located at a side of the first insulating layer opposite to the pixel defining layer, and orthographic projections of the first insulating layer and a peripheral region of the second openings on a plane where the display substrate is located at least partially overlap with each other.

For example, in the display substrate provided by at least one embodiment of the present disclosure, the second opening comprises an intermediate region and the peripheral region, the intermediate region is located within the peripheral region; and an orthographic projection of the intermediate region on the plane where the display substrate is located coincides with an orthographic projection of the corresponding first openings on the plane where the display substrate is located.

For example, in the display substrate provided by at least one embodiment of the present disclosure, a size of the intermediate region is not less than half of a size of the second openings in a first direction parallel to the plane where the display substrate is located.

For example, in the display substrate provided by at least one embodiment of the present disclosure, the first insulating layer is lyophilic and the pixel defining layer is lyophobic.

For example, in the display substrate provided by at least one embodiment of the present disclosure, a cross-sectional shape of the pixel defining layer is step-shaped.

For example, in the display substrate provided by at least one embodiment of the present disclosure, the second opening is an opening of the pixel defining layer close to a side where the first insulating layer is located.

For example, in the display substrate provided by at least one embodiment of the present disclosure, the first electrode layer comprises a plurality of first electrodes, the first electrodes are in a one-to-one correspondence relationship with the plurality of second openings; and the display substrate further comprises a common electrode located at a side of the organic light-emitting functional layers facing away from the first electrode layer.

For example, in the display substrate provided by at least one embodiment of the present disclosure, the display substrate further comprises a reflective layer located between the first electrode layer and the base substrate.

For example, in the display substrate provided by at least one embodiment of the present disclosure, the first electrode layer is configured as a reflective electrode.

For example, in the display substrate provided by at least one embodiment of the present disclosure, the first insulating layer comprises a light shielding material.

For example, the display substrate provided by at least one embodiment of the present disclosure further comprises a black matrix, the black matrix is located at a side of the common electrode facing away from the pixel defining layer, and an orthographic projection of the black matrix on the plane where the display substrate is located is located within an orthographic projection of the first insulating layer on the plane where the display substrate is located.

For example, in the display substrate provided by at least one embodiment of the present disclosure, the organic light-emitting functional layers comprise an organic light-emitting layer and one or a combination of a hole injection layer, a hole transport layer, an electron transport layer, and an electron injection layer.

At least one embodiment of the present disclosure provides a display panel, comprising the display substrate in any of the previous embodiments.

At least one embodiment of the present disclosure provides a manufacturing method of a display substrate, the manufacturing method comprises: forming a first electrode layer; forming a first insulating layer having a plurality of first openings at a side of the first electrode layer; forming a pixel defining layer having a plurality of second openings at a side of the first insulating layer facing away from the base substrate, the plurality of second openings and the plurality of first openings are in a one-to-one correspondence relationship, and at least a portion of the second opening overlaps with the first opening corresponding to the second opening; and forming an organic light-emitting functional layer in the first opening and the second opening which correspond to each other, an orthographic projection of the first insulating layer on a plane where the display substrate is located at least partially overlaps with an orthographic projection of a peripheral region of the second opening on the plane where the display substrate is located.

For example, in the manufacturing method of the display substrate provided by at least one embodiment of the present disclosure, the forming the organic light-emitting functional layer comprises using ink-jet printing.

For example, in the manufacturing method of the display substrate provided by at least one embodiment of the present disclosure, the first electrode layer is formed as a reflective electrode.

For example, the manufacturing method of the display substrate provided by at least one embodiment of the present disclosure further comprises forming a reflective layer at a side of the first electrode layer facing away from the pixel defining layer.

For example, in the manufacturing method of the display substrate provided by at least one embodiment of the present disclosure, the first insulating layer comprises a light shielding material.

### BRIEF DESCRIPTION OF THE DRAWINGS

In order to illustrate the technical solution of the embodiments of the present invention more clearly, the drawings of the embodiments will be briefly introduced as follows. It is obvious that the drawings described herein below only refer to some embodiments of the present invention, rather than are limitative of the present invention.
FIG. 1 is a cross-sectional view of a display substrate provided by some embodiments of the present disclosure;
FIG. 2A is a cross-sectional view of a display substrate provided by some embodiments of the present disclosure;
FIG. 2B is a plan view showing a partial structure of the display substrate shown in FIG. 2A;
FIG. 3 is a cross-sectional view of another display substrate provided by some embodiments of the present disclosure;
FIG. 4 is a cross-sectional view of another display substrate provided by some embodiments of the present disclosure;
FIG. 5 is a cross-sectional view of another display substrate provided by some embodiments of the present disclosure; and
FIG. 6A to FIG. 6D are flow diagrams of a manufacturing method of a display substrate provided by some embodiments of the present disclosure.

### Reference signs:

100-base substrate; 200-first insulating layer; 210-first opening; 300-pixel defining layer; 310-second opening; 311-peripheral region; 312-intermediate region; 400-organic light-emitting element; 410-first electrode layer; 420-second electrode layer; 430-organic light-emitting functional layer; 500-reflective layer; 600-black matrix; 700-encapsulation layer.

### DETAILED DESCRIPTION

In order to make the objects, technical solutions and advantages of the embodiments of the present invention clearer, the technical solutions of the embodiments of the present disclosure will be described clearly and completely with reference to the drawings of the embodiments of the present invention. Apparently, the embodiments described are just part but not all of the embodiments of the present invention. Based on the embodiments of the present invention described, the other embodiments obtained by a person of ordinary skill in the art without any inventive work should be within the scope of protection of the present invention.

Unless otherwise defined, the technical terms or scientific terms used in the present disclosure should have the same meanings as commonly understood by one of ordinary skill in the art to which the present invention belongs. The terms "first," "second," and the like which are used in the present disclosure are not intended to indicate any sequence, amount or importance, but to distinguish various components. The terms "comprise," "comprising," "include," "including," and the like are intended to specify that the elements or the objects stated before these terms encompass the elements or the objects and equivalents thereof listed after these terms, and do not preclude the other elements or objects. The terms "connect", "connected," and the like are not intended to define physical connection or mechanical connection, but may include electrical connection, directly or indirectly. "Above," "below," "left," "right" and the like are only used to indicate a relative position relationship, and if the absolute position of the object described is changed, the relative position relationship may be changed accordingly.

When preparing a structural layer for light emission in OLED, it is necessary to manufacture the corresponding structural layer in an opening of a pixel defining layer. However, the flatness of a portion of the structural layer near an edge of the opening is often poor, resulting in uneven light emission of the portion of the structural layer near the edge of the opening, thus adversely affecting the display effect of OLED products.

At least one embodiment of the present disclosure provides a display substrate, comprising a first insulating layer, a pixel defining layer, a first electrode layer and a plurality of organic light-emitting functional layers, wherein the first insulating layer comprises a plurality of first openings, the pixel defining layer is located at a side of the first insulating layer and comprises a plurality of second openings corresponding to the first openings in a one-to-one correspondence relationship, the second opening communicates with the corresponding first opening, the plurality of organic light-emitting functional layers is located in the second opening, the first electrode layer is located at a side of the first insulating layer opposite to the pixel defining layer, and an orthographic projection of the first insulating layer on a plane where the display substrate is located at least partially overlaps with an orthographic projection of a peripheral region of the second opening on the plane where the display substrate is located. In the display substrate, the first insulating layer may shield a portion of the organic light-emitting functional layer corresponding to the peripheral region of the second opening so that the portion does not contact the first electrode layer and cannot emit light, thereby improving the uniformity of light emitted by the organic light-emitting functional layer and improving the display effect of the display substrate. For example, the display substrate comprises a base substrate, and the above structures are all arranged on the base substrate. For example, the plane where the display substrate is located may be a plane where the base substrate is located.

Next, a display substrate and a manufacturing method thereof, and a display panel according to at least one embodiment of the present disclosure will be described with reference to the accompanying drawings.

It should be noted that in at least one embodiment of the present disclosure, the display substrate may comprise a plurality of pixel regions. Next, a display substrate in at least one embodiment of the present disclosure will be described taking one pixel region of the display substrate as an example.

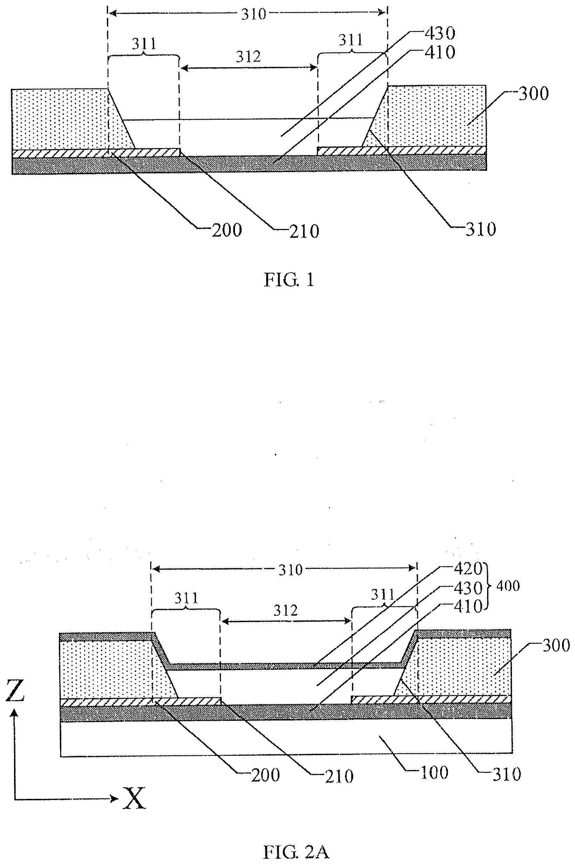

FIG. 1 is a cross-sectional view of a display substrate provided by some embodiments of the present disclosure. For example, the display substrate comprises a plurality of pixel units, and FIG. 1 shows a structure of one pixel unit of the display substrate.

At least one embodiment of the present disclosure provides a display substrate. As shown in FIG. 1, the display substrate may comprise a first insulating layer 200, a pixel defining layer 300, a first electrode layer 410, and a plurality of organic light-emitting functional layers 430. The first insulating layer 200 comprises a first opening 210, the pixel defining layer 300 is located at a side of the first insulating layer 200 and comprises a second opening 310 corresponding to the first opening 210, the second opening 310 communicates with the corresponding first opening 210, the organic light-emitting functional layer 430 is located in the second opening 310, the first electrode layer 410 is located at a side of the first insulating layer 200 opposite to the pixel defining layer 300, and an orthographic projection of the first insulating layer 200 on a plane where the display substrate is located at least partially overlaps with an orthographic projection of a peripheral region 311 of the second opening 310 on the plane where the display substrate is located. For example, the organic light-emitting functional layer 430 communicates with the first electrode layer 410 through the corresponding second opening 310 and the corresponding first opening 210.

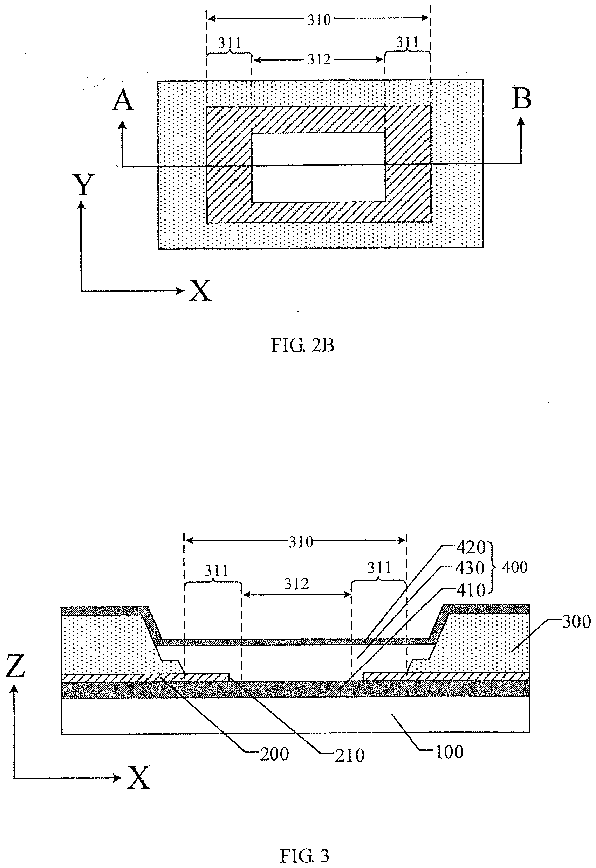

FIG. 2A is a cross-sectional view of a display substrate provided by some embodiments of the present disclosure. FIG. 2B is a plan view showing a partial structure of the display substrate shown in FIG. 2A. FIG. 2A may be a cross-sectional view along A-B shown in FIG. 2B. For example, the display substrate comprises a plurality of pixel units, and FIG. 2A and FIG. 2B show a structure of one pixel unit of the display substrate.

For example, in the display substrate provided by at least one embodiment of the present disclosure, the display substrate may further comprise a base substrate on which the structure shown in FIG. 1 may be disposed. Illustratively, as shown in FIG. 2A and FIG. 2B, the display substrate may comprise a base substrate 100, and a first insulating layer 200, a pixel defining layer 300, a first electrode layer 410, and a plurality of organic light-emitting functional layers 430 which are disposed on the base substrate 100. The first insulating layer 200 is located on the base substrate 100 and comprises a plurality of first openings 210, the pixel defining layer 300 is located at a side of the first insulating layer 200 facing away from the base substrate 100 and comprises a plurality of second openings 310 corresponding to the first openings 210 in a one-to-one correspondence relationship, the second opening 310 communicates with the corresponding first opening 210, the plurality of organic light-emitting functional layers 430 are located in the second opening 310, the first electrode layer 410 is located between the base substrate 100 and the first insulating layer 200, the organic light-emitting functional layer 430 communicates with the first electrode layer 410 through the corresponding second opening 310 and the corresponding first openings 210, and an orthographic projection of the first insulating layer 200 on the base substrate 100 at least partially overlaps with an orthographic projection of a peripheral region 311 of the second opening 310 on the base substrate 100.

The peripheral region of the second opening is located at an edge of the second opening. In a process of manufacturing the organic light-emitting functional layer in the second opening, a portion of the organic light-emitting functional layer located in the peripheral region (a defective portion of the organic light-emitting functional layer) has poor flatness, for example, warpage. In the case where the defective portion can emit light, the light emitted by the defective portion is uneven, for example, the luminance is different at different portions of the defective portion, the luminance of the defective portion is different from that of a portion of the organic light-emitting functional layer located in a middle region of the second openings, and the uniformity of the luminance of the light emitted by the organic light-emitting functional layer is poor, which result in poor displaying. In the embodiments shown in FIG. 2A and FIG. 2B, the first insulating layer 200 may shield the defective portion so that some or all of the defective portion cannot emit light, thus reducing the proportion of uneven light emitted by the defective portion in all light emitted by the organic light-emitting functional layer 430 or making it impossible for the defective portion of the organic light-emitting functional layer to emit light. In this way, the uniformity of light emitted by the organic light-emitting functional layer 430 can be improved, and the display effect of the display substrate can be improved.

For example, in at least one embodiment of the present disclosure, the non-uniformity of light may be a non-uniform distribution of brightness, intensity, color temperature, color purity, and the like.

Next, a spatial rectangular coordinate system is established with reference to the plane where the base substrate is located in the display substrate, so as to explain the positions of various structures in the display substrate. In this spatial rectangular coordinate system, as shown in FIG. 2A and FIG. 2B, a x axis and a y axis are parallel to the plane where the base substrate 100 is located (e.g., a surface of the base substrate 100 facing the pixel defining layer 300), and a z axis is perpendicular to the plane where the base substrate 100 is located.

In at least one embodiment of the present disclosure, the positions of the first opening and the second opening are not limited as long as the first insulating layer may overlap with the peripheral region of the second opening. For example, in the display substrate provided by at least one embodiment of the present disclosure, the second opening comprises an intermediate region and a peripheral region, and the intermediate region is located within the peripheral region. For example, in at least one embodiment of the present disclosure, an orthographic projection of the intermediate region on the plane where the base substrate is located may coincide with an orthographic projection of the corresponding first opening on the plane where the base substrate is located. Illustratively, as shown in FIG. 2A and FIG. 2B, the second opening 310 comprises an intermediate region 312 and a peripheral region 311, wherein the intermediate region 312 is located within the peripheral region 311, and the intermediate region 312 coincides with the first opening 210 in a z-axis direction. In this way, the first insulating layer 200 can shield all portions of the organic light-emitting functional layer 430 located in the peripheral region 311, thereby further improving the uniformity of light emitted by the organic light-emitting functional layer 430 and improving the display effect of the display substrate.

Next, the following technical solution in at least one embodiment of the present disclosure will be described taking that the intermediate region of the second opening coincides with the first opening as an example.

It should be noted that in at least one embodiment of the present disclosure, the specific shapes of the intermediate region and the peripheral region in the second opening are not limited. For example, the shape of the intermediate region may be similar to the shape of the second opening in a direction parallel to the plane where the base substrate is located, and a centroid of the intermediate region coincides with a centroid of the second opening. Illustratively, as shown in FIG. 2B, in the X-Y plane, the planar shapes of the second opening 310 and the intermediate region 311 are both rectangular and similar in shape, and the centroid of the intermediate region 311 coincides with the centroid of the second opening 310.

Next, the following technical solution in at least one embodiment of the present disclosure will be described taking that the shapes of the intermediate region and the second opening are similar and their centroids coincide as an example.

In at least one embodiment of the present disclosure, the specific dimensions of the intermediate region and the peripheral region in the second opening are not limited. For example, in the display substrate provided by at least one embodiment of the present disclosure, a size of the intermediate region is not less than half of a size of the second opening in a first direction parallel to the plane where the display substrate (base substrate) is located. Illustratively, as shown in FIG. 2A and FIG 2B, the size of the intermediate region 312 is not less than half of the size of the second opening 310 in a direction of the x axis (the first direction). For example, a ratio of the size of the intermediate region to the size of the second opening is from 1/2 to 3/4, for example, further from 1/2 to 2/3. In this way, the light-emitting uniformity of the organic light-emitting functional layer can be improved to ensure that the intermediate region 311 has a larger size, so that the organic light-emitting functional layer has a sufficient light-emitting area, and the sufficient brightness and aperture ratio of the pixel region are ensured.

In at least one embodiment of the present disclosure, the structure of the pixel defining layer is not limited. For example, the pixel defining layer may be a one-layer or two-layer structure, or a multi-layer composite layer structure. For example, the pixel defining layer may at least comprise a first defining layer and a second defining layer which are stacked with each other, wherein the first defining layer may be formed of a lyophilic material, and the second defining layer may be formed of a lyophobic material. The first defining layer is located between the base substrate and the second defining layer, and when at least portion of the structural layers (e.g., an organic light-emitting layer, etc.) of the organic light-emitting functional layer is prepared by, for example, ink-jet printing, the first defining layer having lyophilic properties adsorbs and fixes the ink-jet material in the second opening of the pixel defining layer; the second defining layer with lyophobic properties makes the ink-jet material falling thereon slide down and move into the second opening, and can prevent the ink-jet material in the second opening from climbing, which helps improve the flatness of the structural layer formed after the ink-jet material is dried. As such, the uniformity of light emission of the organic light-emitting functional layer can be improved, and the display effect of the display substrate can be improved.

In the display substrate provided by at least one embodiment of the present disclosure, the material of the lyophilic layer in the pixel defining layer may comprise inorganic materials such as lyophilic silicon nitride, silicon oxide (e.g., silicon dioxide), or organic materials containing hydrophilic groups such as hydroxyl group. The material of the lyophobic layer may comprise materials such as polyimide, and may also comprise compounds containing halogens such as fluorine and chlorine.

It should be noted that in at least one embodiment of the present disclosure, lyophobic and lyophilic are defined with respect to ink-jet materials for ink-jet printing. If the material layer has lyophobic property with respect to ink-jet materials for ink-jet printing, the material layer will have lyophobic property, and accordingly, if the material layer has lyophilic property with respect to ink-jet materials for ink-jet printing, the material layer will have lyophilic property.

For example, in the display substrate provided by at least one embodiment of the present disclosure, the first insulating layer may comprise a lyophilic material so as to have lyophilic property. In this way, the pixel defining layer only needs to have lyophobic property, so that the lyophilic design is not required, the difficulty of the manufacturing process of the pixel defining layer can be reduced, the technological process can be simplified, and the cost can be reduced.

For example, in the display substrate provided by at least one embodiment of the present disclosure, the second opening is an opening of the pixel defining layer close to the first insulating layer (the base substrate). Illustratively, as shown in FIG. 2A and FIG. 2B, in the actual process, the second opening 310 of the pixel defining layer 300 may be designed as an inverted trapezoid, and a side surface of the second opening 310 may be an inclined plane, and the second opening 310 of this structure helps adjust the distribution of the ink-jet material in the second opening 310 and improve the flatness of the structural layer formed after the ink-jet material is dried. For the second opening 310 of the above-described structure, a portion of the organic light-emitting functional layer 430 corresponding to an opening of the second opening 310 facing the first insulating layer 200 (or the base substrate 100) can emit light without considering other structures (e.g., the first insulating layer), while a portion of the organic light-emitting functional layer 430 corresponding to the side surface of the second opening 310 cannot be used for emitting light. Therefore, in at least one embodiment of the present disclosure, in the case of describing the size of the second opening and its positional relationship with other structures (e.g., the first opening, the organic light-emitting functional layer, etc.), the second opening 310 is an opening of the pixel defining layer 300 close to the base substrate 100 side.

FIG. 3 is a cross-sectional view of another display substrate provided by some embodiments of the present disclosure.

For example, in the display substrate provided by at least one embodiment of the present disclosure, a cross-sectional shape of the pixel defining layer is step-shaped. Illustratively, as shown in FIG. 3, the cross section of the pixel defining layer 300 is step-shaped. Accordingly, the side surface of the second opening 310 is also step-shaped, and a size of an end of the second opening 310 facing the base substrate 100 is smaller than a size of an end of the second opening 310 facing away from the base substrate 100. In the ink-jet printing process, the second opening 310 having the above structure can improve the uniformity of the distribution of the ink-jet material in the second opening 310, so that the flatness of the structural layer formed after the ink-jet material is dried can be further improved.

In at least one embodiment of the present disclosure, an organic light-emitting element is provided in each pixel region, and may comprise a first electrode layer, an organic light-emitting functional layer, and a second electrode layer, the second electrode layer is located at a side of the organic light-emitting functional layer facing away from the first electrode layer. Illustratively, as shown in FIG. 3, an organic light-emitting element 400 is provided in each pixel region, the organic light-emitting element 400 comprises a first electrode layer 410, an organic light-emitting functional layer 430, and a second electrode layer 420 which are sequentially stacked. For example, a driving circuit layer may be provided between the base substrate and the organic light-emitting element, and the driving circuit layer may be provided to control the light-emitting function of the organic light-emitting element.

For example, in the display substrate provided by at least one embodiment of the present disclosure, the first electrode layer comprises a plurality of first electrodes, the first electrodes correspond to the second openings in a one-to-one correspondence relationship, and the second electrode layer is a common electrode. Illustratively, as shown in FIG. 3, the first electrode layer 410 comprises a plurality of first electrodes spaced apart from each other, and the first electrodes are pixel electrodes and the second electrode layer 420 is a common electrode. For example, a portion of the electrodes of the first electrode layer 410 shown in FIG. 3 is the first electrode.

For example, in at least one implementation of the present disclosure, one of the first electrode layer and the second electrode layer is an anode and the other is a cathode. As a connection layer of a positive voltage of an organic light-emitting element, the anode has good conductivity and visible light transparency and a high work function value. For example, the anode may be formed of a transparent conductive material having a high work function, and an electrode material of the anode may include indium tin oxide (ITO), indium zinc oxide (IZO), indium gallium oxide (IGO), gallium zinc oxide (GZO), zinc oxide (ZnO), indium oxide (In₂O₃), aluminum zinc oxide (AZO), carbon nanotubes, and the like; as a connection layer of negative voltage of an OLED element, the cathode has good conductivity and a low work function value. The cathode may be made of metal materials with low work function values, such as lithium, magnesium, calcium, strontium, aluminum, indium, etc., or alloys of the above metal materials with low work function values and copper, gold and silver.

For example, in the display substrate provided by at least one embodiment of the present disclosure, the organic light-emitting functional layer comprises an organic light-emitting layer. For example, the organic light-emitting functional layer may further comprise one or a combination of a hole injection layer, a hole transport layer, an electron transport layer, an electron injection layer, and the like. For example, in an organic light-emitting element, an anode, a hole injection layer, a hole transport layer, an organic light-emitting layer, an electron transport layer, an electron injection layer, and a cathode are sequentially stacked. For example, an electron blocking layer and a hole blocking layer may also be provided in the organic light-emitting functional layer, the electron blocking layer is located between the anode and the organic light-emitting layer, and the hole blocking layer is located between the cathode and the organic light-emitting layer, but no limitation is made thereto. For example, the hole blocking layer or the electron blocking layer may be made of an organic material.

For example, the hole injection layer may be made of a triphenylamine compound or a P-type doped organic layer or a polymer, such as tris-[4-(5-phenyl-2-thienyl)benzene]amine, 4,4',4"-tris[2-naphthyl(phenyl)amino]triphenylamine (2-TNATA) or 4,4',4"-tris-(3-methylphenylanilino)triphenylamine (m-MTDATA), copper phthalocyanine (CuPc), Pedot:Pss, TPD or F4TCNQ.

The hole transport layer may be made of an aromatic diamine compound, a triphenylamine compound, an aromatic triamine compound, a biphenyl diamine derivative, a triarylamine polymer and carbazole polymers, such as NPB, TPD, TCTA and polyvinyl carbazole or monomers thereof.

For example, the electron transport layer may adopt o-phenanthroline derivatives, oxazole derivatives, thiazole derivatives, imidazole derivatives, metal complexes, and anthracene derivatives. Specific examples include: 8-hydroxyquinoline aluminum (Alq3), 8-hydroxyquinoline lithium (Liq), 8-hydroxyquinoline gallium, bis[2-(2-hydroxyphenyl-1)-pyridine]beryllium, 2-(4-diphenyl)-5-(4-tert-butylphenyl)-1,3,4-oxadiazole (PBD), 1,3,5-tris(N-phenyl-2-benzimidazole-2)benzene (TPBI), BCP, Bphen, and the like.

For example, the electron injection layer may be an alkali metal oxide, an alkali metal fluoride, or the like. The alkali metal oxide includes lithium oxide (Li₂O), lithium boron oxide (LiBO), potassium silicon oxide (K₂SiO₃), cesium carbonate (Cs₂CO₃), and the like. The alkali metal fluoride includes lithium fluoride (LiF), sodium fluoride (NaF), and the like.

For example, the organic light-emitting layer may emit red light, green light, blue light, yellow light, white light, and the like depending upon the different organic light-emitting materials used. The present embodiment is not limited to the color of light emitted by the organic light-emitting layer. In addition, the organic light-emitting material of the organic light-emitting layer of the present embodiment comprises a fluorescent light-emitting material or a phosphorescent light-emitting material as required. For example, the organic light-emitting layer may adopt a doping system, i.e., a usable light-emitting material which is obtained by mixing a doping material into a mainbody luminescent material. For example, the mainbody luminescent material may be a metal complex material, an anthracene derivative, an aromatic diamine compound, a triphenylamine compound, an aromatic triamine compound, a biphenyldiamine derivative, a triarylamine polymer, or the like. For example, bis(2-methyl-8-hydroxyquinoline-N1,O8)-(1,1'-biphenyl-4-hydroxy)aluminum (Balq), 9,10-bis-(2-naphthyl)anthracene (ADN), TAZ, 4,4'-bis(9-carbazole)biphenyl (CBP), MCP, 4,4',4"-tri-9-carbazolyl triphenylamine (TCTA) or N,N-bis(α-naphthyl-phenyl)-4,4-biphenyldiamine (NPB), etc.. Fluorescent luminescent materials or doping materials include, for example, coumarin dyes (coumarin 6, C-545T), quinacridone (DMQA), or 4-(dinitrile methylene)-2-methyl-6-(4-dimethylamino-styrene)-4H-pyran (DCM) and the like. Phosphorescent luminescent materials or doping materials include, for example, luminescent materials based on metal complexes such as Ir, Pt, Ru, Cu, etc., for example, FIrpic, Fir6, FirN4, FIrtaz, Ir(ppy₎₃, Ir(ppy)₂(acac), PtOEP, (btp)₂Iracac, Ir(piq)₂(acac) or (MDQ)₂Iracac, etc.. In addition, the luminescent material may also include doped double mainbodies.

For example, in at least one embodiment of the present disclosure, the organic light-emitting functional layer in the organic light-emitting element is not limited to being completely manufactured by ink-jet printing. For example, it is taken as an example that the first electrode layer is an anode and the organic light emitting functional layer may emit red light, green light and blue light, respectively. For example, in some embodiments of the present disclosure, layers of the organic light-emitting functional layer are all formed by ink-jet printing, a hole injection layer, a hole transport layer, an electron transport layer, and an electron injection layer are formed by ink-jet printing, and a red organic light-emitting layer, a green organic-light emitting layer, and a blue organic light-emitting layer are respectively formed in different second openings (e.g., the second openings and the first openings communicating with the second openings) by ink-jet printing. For example, in other embodiments of the present disclosure, the organic light-emitting functional layer may be formed by ink-jet printing and vapor deposition together. After the hole injection layer and the hole transport layer are formed by ink-jet printing, the red organic light-emitting layer and the green organic light-emitting layer are respectively formed in different second openings (e.g., the second openings and the first openings communicating with the second openings) by ink-jet printing, the blue organic light-emitting layer is formed by vapor deposition, and then the electron transport layer and the electron injection layer are formed by vapor deposition.

In at least one embodiment of the present disclosure, the material of the first insulating layer is not limited. For example, the material of the first insulating layer may include insulating materials such as silicon nitride, silicon oxide, silicon oxynitride, polymer resins, and the like. For example, the first insulating layer may include a photoresist material (photoresist). As such, in the process of manufacturing the first insulating layer, no additional photoresist is required for a patterning process, thus simplifying the manufacturing process of the display substrate and reducing the cost.

For example, in at least one embodiment of the present disclosure, a thickness of the first insulating layer is smaller than a thickness of the organic light-emitting functional layer in a direction perpendicular to the plane where the display substrate is locate (e.g., a plane where the base substrate is located). Thus, the influence of the first insulating layer on the organic light-emitting functional layer can be reduced, and the organic light-emitting functional layer still has a good light-emitting function. For example, in at least one embodiment of the present disclosure, the thickness of the first insulating layer is smaller than a thickness of the structural layer of the organic light-emitting functional layer in contact with the first electrode layer in a direction perpendicular to the plane where the display substrate is located (e.g., the plane where the base substrate is located). Illustratively, taking the first electrode layer as an anode and the organic light-emitting functional layer comprising a hole injection layer in contact with the first electrode layer as an example, the thickness of the first insulating layer is smaller than the thickness of the hole injection layer in a direction perpendicular to the plane where the display substrate is located (e.g., the plane where the base substrate is located). In this way, the adverse effect of the first insulating layer on the organic light-emitting functional layer can be further reduced.

It should be noted that in at least one embodiment of the present disclosure, the thickness of the first insulating layer may be designed to be smaller than the thickness of the structural layer formed by ink-jet printing in the organic light-emitting functional layer. For example, in the case where the organic light-emitting functional layer may be formed by ink-jet printing and vapor deposition together, a hole injection layer and a hole transport layer are formed by ink-jet printing, and an organic light-emitting layer, an electron transport layer and an electron injection layer are formed by vapor deposition. The thickness of the first insulating layer is smaller than the total thickness of the hole injection layer and the hole transport layer in a direction perpendicular to the plane where the display substrate is located (e.g., the plane where the base substrate is located).

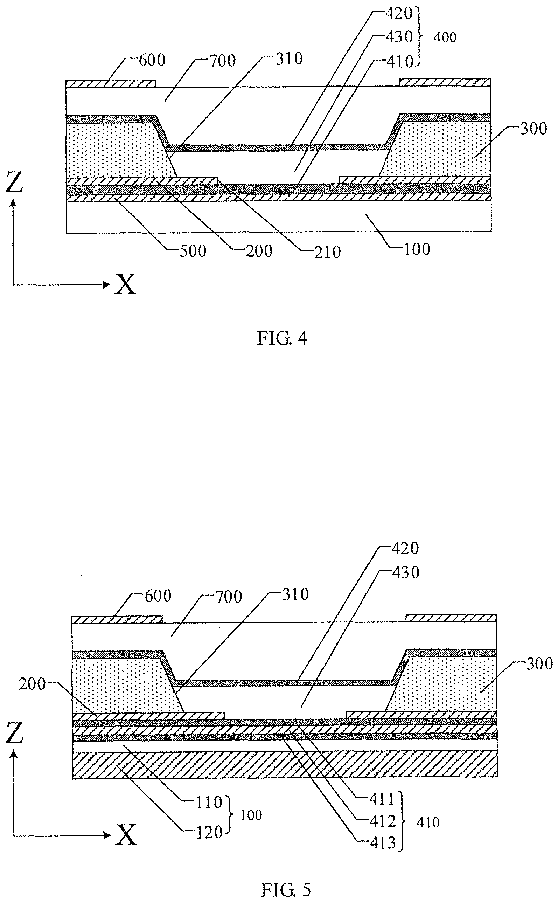

FIG. 4 is a cross-sectional view of another display substrate provided by some embodiments of the present disclosure.

In the display substrate provided by at least one embodiment of the present disclosure, the light-emitting manner of the organic light-emitting element is not limited. For example, in some embodiments of the present disclosure, the organic light-emitting element may be a bottom emission type organic light-emitting element, the second electrode layer may be provided as a reflective electrode, and the first electrode layer may be a transparent electrode or a translucent electrode. For example, in other embodiments of the present disclosure, the organic light-emitting element may be a top emission type organic light-emitting element, the first electrode layer is configured as a reflective electrode or the display substrate further comprises a reflective layer located at a side of the first electrode layer facing away from the pixel defining layer (e.g., between the first electrode layer and the base substrate), and the second electrode layer is a transparent electrode or a translucent electrode. Illustratively, as shown in FIG. 4, the reflective layer 500 is located between the first electrode layer 410 and the base substrate 100. The reflective layer 500 can reflect the light emitted by the organic light-emitting element 400 so that all the light emitted by the organic light-emitting element 400 exits from one side of the display substrate, thereby improving the utilization rate of the light emitted by the organic light-emitting element 400 and improving the brightness of the display image of the display substrate. For example, in the display substrate shown in FIG. 4, the reflective layer 500 may not be provided and the first electrode layer 410 may be provided as a reflective electrode. Accordingly, the structure of the display substrate may be shown in FIG. 2A or FIG. 3. Thus, the structure of the display substrate can be simplified, the manufacturing process of the display substrate can be simplified, and the cost can be reduced.

For example, in at least one embodiment of the present disclosure, transparent may represent a light transmittance of 75% to 100%, and translucent may represent a light transmittance of 50% to 75%.

Next, taking a first electrode layer configured as a reflective electrode as an example, the following technical solution in at least one embodiment of the present disclosure will be described.

For example, in the display substrate provided by at least one embodiment of the present disclosure, the first insulating layer may comprise a light shielding material. For example, the light shielding material may be a light absorbing material such as carbon black or the like. Illustratively, as shown in FIG. 4, the first insulating layer 200 comprises a light shielding material. In this way, the first insulating layer 200 can absorb the light incident into the display substrate from outside and reduce the reflection of external ambient light, thereby reducing the adverse effect of ambient light on the display image of the display substrate and improving the display effect of the display substrate. For example, after the light shielding material is included in the first insulating layer, the first insulating layer may have a non-transparent state or a translucent state. In at least one embodiment of the present disclosure, the non-transparent state indicates that the transmittance of visible light is 0%-25%, and the translucent state indicates that the transmittance of visible light is 25%-50%.

For example, the display substrate provided by at least one embodiment of the present disclosure further comprises a black matrix, wherein the black matrix is located at a side of the common electrode (the second electrode layer) facing away from the pixel defining layer (e.g., a side of the common electrode facing away from the base substrate), and the orthographic projection of the black matrix on the plane where the base substrate is located is located within the orthographic projection of the first insulating layer on the plane where the display substrate is located (e.g., the plane where the base substrate is located). Illustratively, as shown in FIG. 4, the black matrix 600 is located at a side of the second electrode layer 420 facing away from the base substrate 100. The orthographic projection of the black matrix 600 on the plane where the base substrate 100 is located is located within the orthographic projection of the first insulating layer 200 on the plane where the base substrate 100 is located, so that the pixel region can have a larger aperture ratio. A size of the black matrix 600 is smaller than a size of the first insulating layer 200, so that the absorption light from the external environment of the black matrix 600 is limited, and a portion of the external ambient light incident into the display substrate will be further absorbed by the first insulating layer 200. Compared with the black matrix 600, the first insulating layer 200 can further reduce the reflection of the external ambient light, thereby further reducing the adverse effect of the ambient light on the display image of the display substrate and improving the display effect of the display substrate.

FIG. 5 is a cross-sectional view of another display substrate provided by some embodiments of the present disclosure.

For example, in at least one embodiment of the present disclosure, the display substrate may further comprise an encapsulation layer located at a side of the common electrode (the second electrode layer) facing away from the base substrate. Illustratively, as shown in FIG. 5, the display substrate comprises an encapsulation layer 700 disposed at a side of the second electrode layer 420 facing away from the base substrate 100. The encapsulation layer 700 can encapsulate the display substrate to prevent external water, oxygen and the like from invading the interior of the display substrate, thereby protecting components (such as an organic light-emitting element) inside the display substrate.

For example, the encapsulation layer 700 may be a single-layer structure or a composite structure of at least two layers. For example, the material of the encapsulation layer 700 may include insulating materials such as silicon nitride (SiNₓ), silicon oxide (SiOₓ), silicon oxynitride (SiNₓO_{y}), polymer resins, and the like. For example, the encapsulation layer 300 may include a first encapsulation layer, a second encapsulation layer, and a third encapsulation layer which are sequentially disposed on the base substrate 100, and the second encapsulation layer is located between the first encapsulation layer and the third encapsulation layer.

For example, materials of the first encapsulation layer and the third encapsulation layer may include an inorganic material such as silicon nitride, silicon oxide, silicon oxynitride, and the like. The inorganic material has high compactness and can prevent invasion of water, oxygen, and the like. For example, the first encapsulation layer and the third encapsulation layer may be formed by a process such as Chemical Vapor Deposition (CVD). For example, the material of the second encapsulation layer may be a polymer material containing a desiccant or a polymer material capable of blocking water vapor, such as a polymer resin or the like, and may also be a water absorbent material, such as an alkali metal (e.g., Li, Na), an alkaline earth metal (e.g., Ba, Ca) or other moisture reactive metals (e.g., Al, Fe); it may also be alkali metal oxide (e.g., Li₂O, Na₂O), alkaline earth metal oxide (e.g., MgO, CaO, BaO), sulfate (e.g., anhydrous MgSO₄), metal halide (e.g., CaCl₂) or perchlorate (e.g., Mg(ClO₄)₂), etc.. The second encapsulation layer can planarize the surface of the display substrate, and can relieve the stress of the first encapsulation layer and the third encapsulation layer. The second encapsulation layer may be provided with a material such as a desiccant, which can absorb substances such as water and oxygen invading the interior to protect components (e.g., the organic light-emitting functional layers, etc.) in the display substrate.

For example, in at least one embodiment of the present disclosure, the display substrate may be an array substrate. Illustratively, as shown in FIG. 5, the base substrate 100 may include a substrate 120 and a thin film transistor layer 110, the thin film transistor layer 110 including a plurality of thin film transistors (TFTs) arranged into an array on the substrate 120. For example, at least one thin film transistor is provided in each pixel region, and the first electrode layer 410 may be electrically connected to a drain electrode of the thin film transistor. In this way, the thin film transistor can control a voltage on the first electrode layer 410 (the first electrode), thereby controlling the operating state of the organic light-emitting element, and further controlling the switch of the display function of the display substrate and the display gray scale. For example, the thin film transistor layer 110 may further include a buffer layer, a gate insulating layer, an interlayer insulating layer, a passivation layer, a planarization layer, and the like.

In at least one embodiment of the present disclosure, the display substrate may be a rigid substrate; or the display substrate may also be a flexible substrate, so that the display substrate may be applied to the flexible display field. For example, when the display substrate is a rigid substrate, the substrate may be a glass plate, a quartz plate, a metal plate, a resin plate, or the like. For example, when the display substrate is a flexible substrate, a material of the substrate may include an organic material, for example, the organic material may be a resin material such as polyimide, polycarbonate, polyacrylate, polyetherimide, polyethersulfone, polyethylene terephthalate, polyethylene naphthalate, or the like.

For example, in at least one embodiment of the present disclosure, the display substrate may be used in the micro OLED display field, and accordingly, the substrate may be a silicon wafer. For example, a material of the silicon wafer may be monocrystalline silicon, and a plane shape of the silicon wafer may be circular or any other shapes.

Next, taking a display substrate as a flexible substrate as an example, the following technical solution in at least one embodiment of the present disclosure will be described.

For example, in at least one embodiment of the present disclosure, as shown in FIG. 5, the first electrode layer 410 may comprise a plurality of film layers, such as a first film layer 411, a second film layer 412, and a third film layer 413 which are stacked with each other. For example, the first film layer 411 and the third film layer 413 may comprise ITO, and the second film layer 412 is a reflective layer and comprises a metal conductive material. When the display substrate is bent, a stress in the first electrode layer 410 having a plurality of film layers is easily released, reducing the risk of stress concentration, thereby preventing the first electrode layer 410 from breaking; in addition, in the case where one or two of the film layers are broken, or in the case where all three film layers are broken but the broken positions are different in the three film layers, because all three film layers are conductive materials and are in contact with each other, the electrical performance of the first electrode layer 410 is not affected, and the yield of the display substrate is improved.

At least one embodiment of the present disclosure provides a display panel comprising the display substrate according to any of the previous embodiments. For example, in the display panel provided by at least one embodiment of the present disclosure, an encapsulating cover plate may be provided at a display side of the display panel. For example, in the display panel provided by at least one embodiment of the present disclosure, a touch substrate may be provided at the display side of the display substrate to enable the display panel to obtain a touch display function.

For example, in the display panel provided by at least one embodiment of the present disclosure, the display side of the display substrate may be provided with a polarized layer, which may include structures such as a polarized sheet, a retardation sheet (e.g., a 1/4 wave sheet, etc., so that light incident into the display substrate from the external environment will not exit from the display substrate, thereby eliminating adverse effects of ambient light on the display image of the display panel and improving the display effect of the display panel.

For example, in the display panel provided by at least one embodiment of the present disclosure, the display side of the display substrate may be provided with a color filter. The color filter can absorb light from the external environment, thereby reducing the adverse effect of ambient light on the display image of the display panel and improving the display effect of the display panel. For example, in the display panel provided by at least one embodiment of the present disclosure, the display side of the display panel may be provided with a light splitting element (e.g., a light splitting grating, etc.), so that the display panel may have a three-dimensional display function.

For example, the display panel may be any product or component with display function such as a TV, a digital camera, a cellphone, a watch, a tablet PC, a laptop, a navigator, or the like.

It should be noted that the entire structure of the display panel is not described for clarity. In order to realize the necessary functions of the display panel, those skilled in the art may set other structures according to specific application scenarios, and the embodiments of the present disclosure are not limited thereto.

At least one embodiment of the present disclosure provides a manufacturing method of a display substrate, comprising: forming a first electrode layer; forming a first insulating layer having a plurality of first openings at a side of the first electrode layer; forming a pixel defining layer having a plurality of second openings at a side of the first insulating layer opposite to the first electrode layer, wherein the second openings correspond to the first openings in a one-to-one correspondence relationship, and the second opening and the corresponding first opening at least partially overlap with each other; and forming an organic light-emitting functional layer in the second opening; wherein an orthographic projection of the first insulating layer on the base substrate at least partially overlaps with an orthographic projection of a peripheral region of the second opening on the base substrate. For example, the organic light-emitting functional layer communicates with the first electrode layer through the corresponding second opening and the corresponding first opening. For example, a base substrate may be provided and the above-described manufacturing process may be performed on the base substrate. In the display substrate obtained by the above manufacturing method, the first insulating layer can shield a portion of the organic light-emitting functional layer corresponding to the peripheral region of the second opening so that the portion does not contact the first electrode layer and cannot emit light, thereby improving the uniformity of light emitted by the organic light-emitting functional layer and improving the display effect of the display substrate.

For example, in the manufacturing method of the display substrate provided by at least one embodiment of the present disclosure, a method of forming the organic light-emitting functional layer includes ink-jet printing. For example, all layers of the organic light-emitting functional layer may be formed by ink-jet printing, or the organic light-emitting functional layer may be formed by ink-jet printing and vapor deposition together. For the structure of the organic light-emitting functional layer and the formation of the organic light-emitting functional layer by different methods, reference may be made to the relevant contents in the previous embodiments and will not be described here.

For example, in the manufacturing method of the display substrate provided by at least one embodiment of the present disclosure, the first electrode layer is formed as a reflective electrode; or a reflective layer is formed at a side of the first electrode layer facing away from the pixel defining layer, for example, the reflective layer is formed between the first electrode layer and the base substrate. The reflective layer or the reflective electrode can reflect the light emitted by the organic light-emitting element, so that the light emitted by the organic light-emitting element (the organic light-emitting functional layer) is totally emitted from one side of the display substrate, thereby improving the utilization rate of the light emitted by the organic light-emitting element and improving the brightness of the display image of the display substrate.

For example, in the manufacturing method of the display substrate provided by at least one embodiment of the present disclosure, the first insulating layer comprises a light shielding material. In this way, the first insulating layer can absorb light incident into the display substrate from the outside and reduce the reflection of external ambient light, thereby reducing the adverse effect of ambient light on the display image of the display substrate and improving the display effect of the display substrate.

It should be noted that a structure of the display substrate obtained according to the above-mentioned manufacturing method may refer to the relevant contents in the previous embodiments (for example, the embodiments shown in FIG. 2A to FIG. 5) and will not be described in detail here.

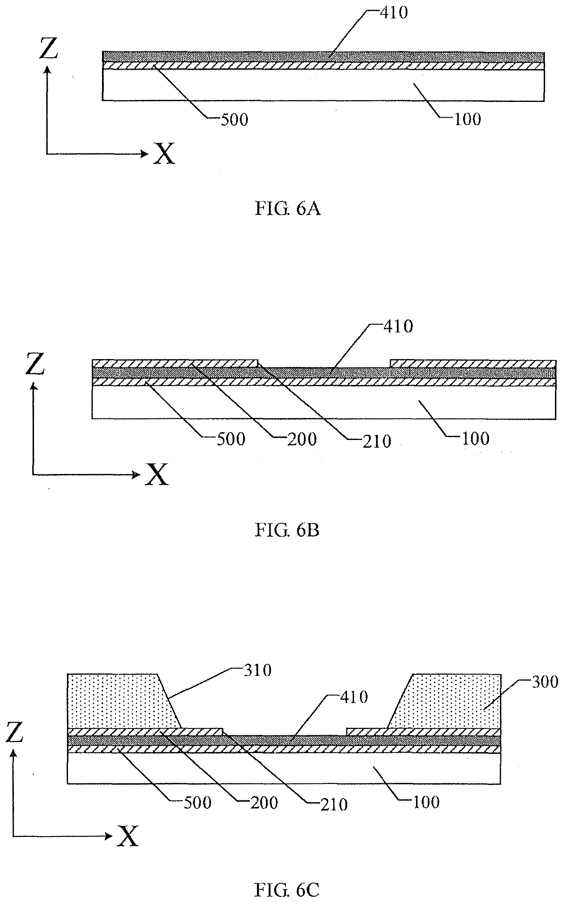

FIG. 6A to FIG. 6D are flow diagrams of a manufacturing method of a display substrate provided by some embodiments of the present disclosure. In at least one embodiment of the present disclosure, taking the manufacturing of the display substrate as shown in FIG. 4 as an example, the manufacturing process of the display substrate may include the following processes as shown in FIG. 6A to FIG. 6D and FIG. 4.

As shown in FIG. 6A, providing a base substrate 100 and forming a reflective layer 500 and a first electrode layer 410 on the base substrate 100, wherein the reflective layer 500 is formed between the first electrode layer 410 and the base substrate 100.

For example, the base substrate 100 may be an array substrate formed with a plurality of thin film transistors, and a structure of the array substrate may refer to the relevant description in the previous embodiments. There are many types of thin film transistors, such as a bottom gate type thin film transistor, a top gate type thin film transistor, a double gate type thin film transistor, and the like. A structure and manufacturing process of the array substrate may be designed according to the type of thin film transistor. Illustratively, the thin film transistor is a bottom gate type thin film transistor, and the manufacturing process of the base substrate includes sequentially forming a buffer layer, a gate electrode, a gate insulating layer, an active layer, an interlayer insulating layer, a source-drain electrode layer, a passivation layer, and the like on the substrate. For example, the manufacturing process of the base substrate may further include forming a planarization layer on the passivation layer.

For example, the first electrode layer comprises a plurality of first electrodes. For example, after depositing a conductive material thin film on the reflective layer 500, the conductive material thin film is subjected to a patterning process to be formed into a first electrode layer comprising a plurality of first electrodes.

For example, in at least one embodiment of the present disclosure, the patterning process may be a photolithographic patterning process, which may include, for example, coating a photoresist layer on a structural layer to be patterned, exposing the photoresist layer using a mask, developing the photoresist layer exposed to obtain a photoresist pattern, etching the structural layer using the photoresist pattern, and then optionally removing the photoresist pattern. It should be noted that if the structural layer patterned comprises a photoresist material, a photoresist coating process may not be required.

As shown in FIG. 6B, an insulating material thin film is deposited on the first electrode layer 410, and a plurality of first openings 210 are formed after patterning the insulating material thin film. The first opening 210 exposes the first electrode layer 410.

As shown in FIG. 6C, an insulating material thin film is deposited on the first insulating layer 200, and a pixel defining layer 300 is formed after patterning the insulating material thin film, the pixel defining layer 300 comprising a plurality of second openings 310. The second openings 310 and the first openings 210 are in a one-to-one correspondence relationship and communicate with each other. For example, the material of the pixel defining layer 310 may be a photoresist material (photoresist). In this way, no additional photoresist needs to be used in the patterning process, which can simplify the manufacturing process of the display substrate and reduce the cost.

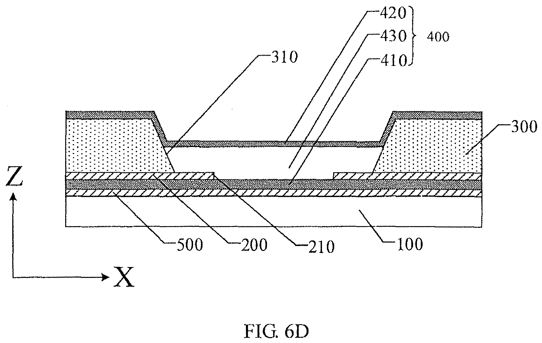

As shown in FIG. 6D, an organic light-emitting functional layer 430 is formed in the first opening 210 and the second opening 310, and a conductive material thin film is deposited at a side of the organic light-emitting functional layer 430 facing away from the base substrate 100 to form a common electrode (the second electrode layer 420). For example, the second electrode layer 420 is formed by vapor deposition. For example, the organic light-emitting functional layer 430 is formed by ink-jet printing, or the organic light-emitting functional layer 430 is formed by ink-jet printing and vapor deposition. The structure of the organic light-emitting functional layer 430 and the method of forming the same may be refer to the relevant descriptions in the previous embodiments and will not be described in detail here.

As shown in FIG. 4, an insulating material is deposited at a side of the second electrode layer 420 facing away from the base substrate 100 to form an encapsulation layer 700. A black matrix 600 is formed at a side of the encapsulation layer 700 facing away from the base substrate 100. The structures of the black matrix 600 and the encapsulation layer 700 may refer to the previous embodiments and will not be described in detail here.

At least one embodiment of the present disclosure provides a display substrate, a manufacturing method thereof, and a display panel, and can have at least one of the following beneficial effects:

(1) In the display substrate provided by at least one embodiment of the present disclosure, the first insulating layer can shield a portion of the organic light-emitting functional layer corresponding to the peripheral region of the second opening, so that the portion does not contact the first electrode layer, thereby preventing the portion from emitting light, improving the uniformity of light emitted by the organic light-emitting functional layer, and improving the display effect of the display substrate.

(2) In the display substrate provided by at least one embodiment of the present disclosure, the first insulating layer may comprise a light shielding material, which can absorb light incident into the display substrate from the outside and reduce reflection of external ambient light, thereby reducing adverse effects of ambient light on the display image of the display substrate and improving the display effect of the display substrate.

For the present disclosure, the following points need to be explained:
(1) The accompanying drawings involve only the structure(s) in connection with the embodiment(s) of the present disclosure, and for other structure(s), reference may be made to common design(s).
(2) For the purpose of clarity, in the accompanying drawings for describing the embodiment(s) of the present disclosure, the thickness of a layer or region may be zoomed-in or zoomed-out, that is, the accompanying drawings are not drawn in an actual scale.
(3) Without conflict, the embodiments of the present disclosure and the features in the embodiments can be combined with each other to obtain new embodiments.

The above are only specific embodiments of the present disclosure, but the scope of protection of the present disclosure is not limited thereto and shall be based on the scope of protection of the claims.

## Claims

1. A display substrate, comprising:
a first insulating layer, comprising a plurality of first openings;
a pixel defining layer, located at a side of the first insulating layer and comprising a plurality of second openings, the plurality of second openings and the plurality of first openings being in a one-to-one correspondence relationship, the second opening communicating with the first opening corresponding to the second opening;
a plurality of organic light-emitting functional layers, located in plurality of second openings; and
a first electrode layer, located at a side of the first insulating layer opposite to the pixel defining layer,
wherein an orthographic projection of the first insulating layer on a plane where the display substrate is located at least partially overlaps with an orthographic projection of a peripheral region of the second opening on the plane where the display substrate is located.

2. The display substrate according to claim 1, wherein
the second opening comprises an intermediate region and the peripheral region, the intermediate region is located within the peripheral region; and
an orthographic projection of the intermediate region on the plane where the display substrate is located coincides with an orthographic projection of the first opening corresponding to the second opening on the plane where the display substrate is located.

3. The display substrate according to claim 2, wherein
a size of the intermediate region is not less than half of a size of the second opening in a first direction parallel to the plane where the display substrate is located.

4. The display substrate according to any one of claims 1 to 3, wherein
the first insulating layer is lyophilic, and the pixel defining layer is lyophobic.

5. The display substrate according to any one of claims 1 to 4, wherein
a cross-sectional shape of the pixel defining layer is step-shaped.

6. The display substrate according to any one of claims 1 to 5, wherein
the second opening is an opening of the pixel defining layer close to a side where the first insulating layer is located.

7. The display substrate according to any one of claims 1 to 6, wherein
the first electrode layer comprises a plurality of first electrodes, the plurality of first electrodes and the plurality of second openings are in a one-to-one correspondence relationship; and
the display substrate further comprises a common electrode located at a side of the plurality of organic light-emitting functional layers facing away from the first electrode layer.

8. The display substrate according to any one of claims 1 to 7, wherein
the display substrate further comprises a reflective layer located at a side of the first electrode layer facing away from the pixel defining layer.

9. The display substrate according to any one of claims 1 to 7, wherein
the first electrode layer is configured as a reflective electrode.

10. The display substrate according to any one of claims 1 to 9, wherein
the first insulating layer comprises a light shielding material.

11. The display substrate according to any one of claims 1 to 10, further comprising:
a black matrix, located at a side of the common electrode facing away from the pixel defining layer,
wherein an orthographic projection of the black matrix on the plane where the display substrate is located is located within an orthographic projection of the first insulating layer on the plane where the display substrate is located.

12. The display substrate according to any one of claims 1 to 11, wherein
the plurality of organic light-emitting functional layers comprise an organic light-emitting layer, and one or a combination of a hole injection layer, a hole transport layer, an electron transport layer, and an electron injection layer.

13. A display panel, comprising the display substrate according to any one of claims 1 to 12.

14. A manufacturing method of a display substrate, comprising:
forming a first electrode layer;
forming a first insulating layer having a plurality of first openings at a side of the first electrode layer;
forming a pixel defining layer having a plurality of second openings at a side of the first insulating layer opposite to the first electrode layer, wherein the plurality of second openings and the plurality of first openings are in a one-to-one correspondence relationship, at least a portion of the second opening overlaps with the first opening corresponding to the second opening; and
forming an organic light-emitting functional layer in the first opening and the second opening which correspond to each other;
wherein an orthographic projection of the first insulating layer on a plane where the display substrate is located at least partially overlaps with an orthographic projection of a peripheral region of the second opening on the plane where the display substrate is located.

15. The manufacturing method according to claim 14, wherein
the forming an organic light-emitting functional layer comprises using ink-jet printing.

16. The manufacturing method according to claim 14 or 15, wherein
the first electrode layer is formed as a reflective electrode.

17. The manufacturing method according to claim 14 or 15, further comprising:
forming a reflective layer at a side of the first electrode layer facing away from the pixel defining layer.

18. The manufacturing method according to any one of claims 14 to 17, wherein the first insulating layer comprises a light shielding material.
